# DEMANDE DE BREVET EUROPEEN

(11) **EP 2 960 868 A2**
(43) Date de publication de la demande: **30.12.2015**
(21) Numéro de dépôt: 15167281.3
(22) Date de dépôt: 12.05.2015
(51) Int. Cl.: G06T 19/00

(54) **PROCEDE DE GENERATION D'UNE MAQUETTE NUMERIQUE ENRICHIE**

(30) Priorité: 04.06.2014 FR 1455054
(71) Demandeur: Airbus Group SAS, 75016 Paris (FR)
(72) Inventeur: Chevassus, Nicolas, 92370 CHAVILLE (FR); Marraud, Denis, 92130 ISSY LES MOULINEAUX (FR); Tarault, Antoine, 75012 PARIS (FR); Perrotton, Xavier, 92320 CHATILLON (FR)
(74) Mandataire: Ipside

(57) **Abrégé**

La présente invention se rapporte à un procédé (10) de génération d'une maquette numérique comportant les étapes suivantes : conception (11) d'une maquette numérique en trois dimensions (X, Y, Z) au moyen d'un logiciel de conception assisté par ordinateur (CAO), intégration (12) de ladite maquette numérique dans un environnement de spatialisation de ladite maquette numérique permettant de visualiser ladite maquette numérique suivant différents angles de vision, réalisation (13) de ladite maquette numérique afin d'obtenir un produit semi-fini, acquisition (14) de plusieurs informations de réalisation, et, pour chaque information de réalisation : mesure (15) d'une position spatiale liée à ladite information de réalisation, et intégration (16) de ladite information de réalisation dans l'environnement de spatialisation sur ladite maquette numérique au niveau d'une position de ladite maquette numérique correspondant à la position spatiale mesurée.

## Description

### Domaine de l'invention

La présente invention se rapporte à un procédé de génération d'une maquette numérique enrichie, c'est-à-dire comportant des informations issues d'un bureau d'étude et des informations issues d'une phase de réalisation.

L'invention trouve une application dans un grand nombre de domaines tels que l'aéronautique, le bâtiment, la construction marine ou encore la construction spatiale.

La présente invention s'applique plus particulièrement aux objets de grande taille tels que les aéronefs, les hélicoptères ou encore les satellites.

### Etat de la technique

La connaissance de l'état d'un objet réel en cours de fabrication ou en service est souvent partielle. Un industriel dispose généralement de recueil de mesures dans des dossiers de fichiers (par exemple des tableurs, des photos ou des fichiers de mesure) ou dans des bases de données. Il est alors difficile, et en particulier pour des objets de grande taille, non seulement de retrouver les mesures issues du réel et associées à une zone particulière et de comprendre où les mesures ont été effectuées mais surtout de les relier et de les mettre en correspondance entre elles ou en regard d'une maquette numérique de conception en trois dimensions. De ce fait, la compréhension de l'état en cours de fabrication ou en service n'est pas aisée.

La conception d'un objet de grande taille nécessite souvent la réalisation d'une maquette de construction. Afin d'améliorer la précision de cette maquette, elle peut être réalisée en trois dimensions au moyen d'un logiciel de conception assisté par ordinateur (CAO). Certains logiciels, par exemple le logiciel CATIA (marque déposée par la société Dassault Système), permettent d'intégrer la maquette numérique dans un environnement de spatialisation permettant de visualiser la maquette numérique suivant différents angles de vision. Cette maquette numérique permet ainsi de guider les maîtres d'oeuvre lors de la réalisation du produit fini.

Avant d'obtenir un produit fini, des opérateurs effectuent des contrôles réguliers des étapes de réalisation sur le produit en cours de réalisation ou produit « semi-fini ». Ces étapes de contrôle permettent d'acquérir plusieurs informations de réalisation qui peuvent différer de la définition attendue sur la maquette numérique. Par exemple, dans le domaine de l'aéronautique, la construction d'un aéronef est contrôlée à chaque étape pour des opérateurs de contrôle qualité qui ont pour rôle de détecter et de déclarer des « non-conformités » entre la maquette numérique et le produit réalisé ou en cours de réalisation, dit produit semi-fini.

La prise de décision en cas d'écart à la définition attendue nécessite des visites sur le terrain pour se rendre compte de visu de l'état du produit semi-fini. Les visites sur le terrain permettent d'accéder à une définition de l'objet réel en cours de fabrication ou en service via des requêtes spatiales croisées, de pouvoir synthétiser des relevés de terrain, mesures ou annotations, et d'analyser les écarts du produit réel avec sa maquette numérique de conception.

Actuellement, l'ensemble des références hétéroclites est généralement regroupé dans une ou plusieurs bases de données (et parfois simplement via fichiers). Ces données peuvent être gérées en configuration dans des systèmes de gestion de configuration et sont accessibles suite à des requêtes sous forme de listes. Les résultats de simulation ou d'essais peuvent être remontés sur les maillages qui ont été utilisés pour leur obtention ou pour leur prédiction mais d'une part les maillages sont déjà des représentations idéalisés du produit et issus de la CAO de conception et d'autre part les environnements permettant cette visualisation sont dédiés au calcul et à l'analyse de composantes physiques spécifiques. En ce sens, ils ne permettent pas de synthétiser la capture du produit réel en regard de sa définition de référence mise en forme par une maquette numérique.

### Exposé de l'invention

La présente invention entend remédier aux inconvénients de l'art antérieur en proposant un environnement de spatialisation en trois dimensions de la maquette numérique enrichie par des informations de réalisation du produit fini ou du produit semi-fini.

A cet effet, le présente invention concerne un procédé de génération d'une maquette numérique comportant les étapes suivantes : conception d'une maquette numérique en trois dimensions au moyen d'un logiciel de conception assisté par ordinateur (CAO), intégration de la maquette numérique dans un environnement de spatialisation de ladite maquette numérique permettant de visualiser ladite maquette numérique suivant différents angles de vision, réalisation de ladite maquette numérique afin d'obtenir un produit semi-fini, acquisition de plusieurs informations de réalisation, et pour chaque information de réalisation : mesure d'une position spatiale liée à ladite information de réalisation, et intégration de ladite information de réalisation dans l'environnement de spatialisation sur ladite maquette numérique au niveau d'une position de ladite maquette numérique correspondant à la position spatiale mesurée.

L'invention permet ainsi d'obtenir une maquette numérique enrichie, c'est-à-dire contenant les informations de conception et des informations de réalisation. Cette maquette numérique enrichie permet de réaliser des contrôles de qualité entre le produit semi-fini et la maquette numérique. En outre, l'invention permet la déclaration et la documentation de non-conformités en réalité augmentée sur un produit semi-fini et leur exploitation dans ledit logiciel de dessin industriel.

Par exemple, dans le domaine de l'aéronautique, une non-conformité peut être détectée par un opérateur de contrôle différent de la personne qui est compétent pour réparer ce problème. Cette détection de non-conformité entraîne un processus d'étude de la non-conformité et, si besoin, de correction de cette non-conformité. La géolocalisation des non-conformités dans l'environnement de spatialisation permet de faciliter les étapes d'étude et de correction en plus de limiter les détections multiples des non-conformités. En outre, la géolocalisation des non-conformités dans l'environnement de spatialisation permet, le cas échéant, de résoudre des erreurs de conception de la maquette numérique.

Selon un mode de réalisation, l'information de réalisation correspond à une mesure d'une pièce dudit produit semi-fini. Ce mode de réalisation permet d'intégrer les contrôles de qualités qui sont effectués sur ledit produit semi-fini et d'en déduire une mesure de tolérance de la réalisation.

Selon un mode de réalisation, l'information de réalisation correspondant à une prise de vue d'une partie dudit produit semi-fini, le procédé comporte une étape d'adaptation de ladite prise de vue à ladite maquette numérique. Ce mode de réalisation permet d'intégrer les prises de vue de deux ou trois dimensions dans l'environnement de spatialisation. En particulier, ce mode de réalisation est particulièrement efficace pour effectuer un contrôle du positionnement de plusieurs éléments d'un produit semi-fini.

Selon un mode de réalisation, l'information de réalisation correspondant à une mesure en trois dimensions d'une surface dudit produit semi-fini, le procédé comporte une étape de mise en correspondance et d'intégration de ladite surface adaptée à ladite maquette numérique. Ce mode de réalisation permet d'intégrer les mesures surfaciques dans l'environnement de spatialisation. En particulier, ce mode de réalisation permet de détecter les impacts sur une structure d'un produit semi-fini. Dans le cas d'une structure composite, chaque impact non détecté peut provoquer un affaiblissement de la structure.

Selon un mode de réalisation, l'information de réalisation correspondant à une pluralité d'annotations relatives à une même position spatiale, le procédé comporte une étape d'imbrication des annotations ponctuelles localisées dans une même zone. Ce mode de réalisation permet de limiter les calculs nécessaires à la visualisation de la maquette numérique et/ou dudit produit semi-fini dans l'environnement de spatialisation.

Selon un mode de réalisation, l'environnement de spatialisation comportant plusieurs niveaux de détails associés à plusieurs masques, le procédé comporte une étape consistant à masquer certaines informations de réalisation ou certaines informations de ladite maquette numérique en fonction d'un niveau de détails sélectionné. Ce mode de réalisation permet également de limiter les calculs nécessaires à la visualisation de la maquette numérique et/ou dudit produit semi-fini dans l'environnement de spatialisation.

Selon un mode de réalisation, le procédé comporte une étape consistant à masquer certaines informations de réalisation ou certaines informations de ladite maquette numérique en fonction de la position de visualisation dans ledit environnement de spatialisation. Ce mode de réalisation permet également de limiter les calculs nécessaires à la visualisation de la maquette numérique et/ou dudit produit semi-fini dans l'environnement de spatialisation, par exemple les éléments présents dans un boitier fermé.

Selon un mode de réalisation, certaines informations de réalisation étant associées à une date, le procédé comporte une étape consistant à masquer certaines informations de réalisation en fonction d'une date sélectionnée. Ce mode de réalisation permet de visualiser l'évolution d'un produit semi-fini au cours de sa réalisation.

Selon un mode de réalisation, le procédé comporte les étapes suivantes : acquisition de plusieurs informations de maintenance, et, pour chaque information de maintenance : mesure d'une position spatiale liée à ladite information de maintenance, et intégration de ladite information de maintenance dans l'environnement de spatialisation sur ladite maquette numérique au niveau d'une position de ladite maquette numérique correspondant à la position spatiale mesurée.

Ce mode de réalisation permet de faciliter la maintenance d'un produit fini en intégrant les mesures d'usures. Cette maquette numérique enrichie permet d'obtenir une évolution des défauts du produit fini. Cette maquette numérique enrichie constitue également une documentation des opérations d'interventions s'appuyant sur un contenu enrichie entre un contenu réel et virtuel. Ce mode de réalisation permet également d'améliorer la compréhension et la recherche des instrumentations de tests sur les produits finis.

### Brève description des dessins

On comprendra mieux l'invention à l'aide de la description, faite ci-après à titre purement explicatif, d'un mode de réalisation de l'invention, en référence aux Figures dans lesquelles :
- la Figure 1 constitue un ordinogramme représentant le procédé selon un mode de réalisation de l'invention ; et
- la Figure 2 illustre un environnement de spatialisation selon un mode de réalisation de l'invention.

### Description détaillée des modes de réalisation de l'invention

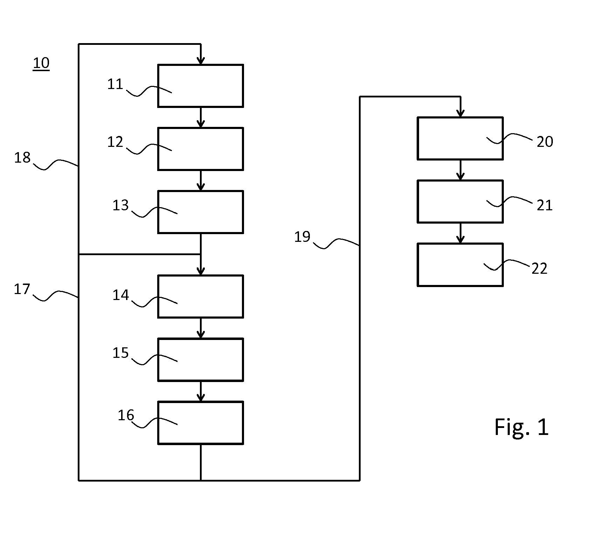

La Figure 1 constitue un ordinogramme représentant le procédé selon un mode de réalisation de l'invention. Dans une première étape de conception 11, un produit est imaginé et conçu dans un bureau d'étude. Cette étape de conception 11 permet d'aboutir à une maquette numérique 30 en trois dimensions X, Y et Z. Dans une seconde étape d'intégration 12, la maquette numérique 30 est implémentée dans un environnement de spatialisation 31 permettant de visualiser ladite maquette numérique 30 suivant différents angles de vision. L'environnement de spatialisation 31 correspond à un moteur graphique, de préférence en trois dimensions. Cet environnement de spatialisation 31 permet d'observer la maquette numérique 30 avec une grande précision afin de faciliter les étapes de réalisation 13 de la maquette numérique 30.

Au cours des étapes de réalisation 13 du produit semi-fini, il est nécessaire d'effectuer des contrôles de la qualité du produit semi-fini. Pour ce faire, des opérateurs réalisent une étape d'acquisition 14 d'informations de réalisation 35-39. Pour chaque information de réalisation 35-39 qui est collectée, l'opérateur mesure 15 une position spatiale liée à l'information de réalisation 35-39 collectée par exemple à l'aide d'un dispositif de géolocalisation. L'information de réalisation 35-39 collectée est alors intégrée 16 dans l'environnement de spatialisation 31 sur la maquette numérique 30 au niveau d'une position de ladite maquette numérique 30 correspondant à la position spatiale mesurée.

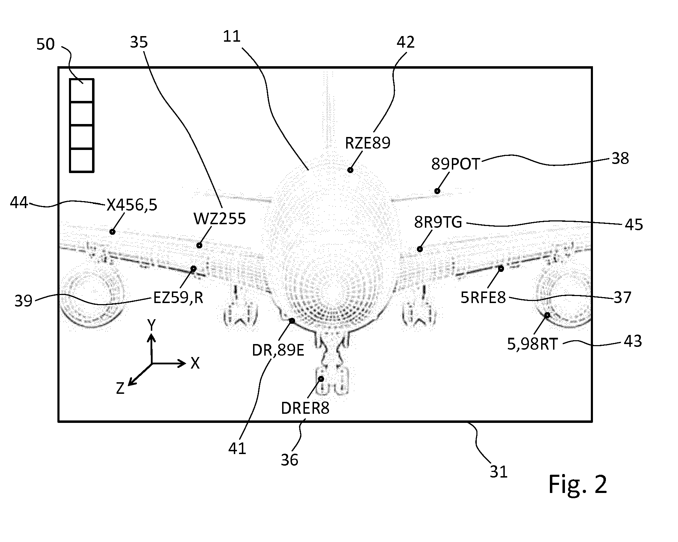

L'environnement de spatialisation 31 ainsi obtenu est représenté sur la Figure 2. La maquette numérique 30, représentant un aéronef, est intégrée en trois dimensions X, Y et Z au centre de l'environnement de spatialisation 31. Les informations de réalisation 35-39 sont géolocalisées sur la structure de l'aéronef au niveau de la position spatiale mesurée. Les informations de réalisation 35-39 peuvent être de différents types. Les informations de réalisation 35-39 peuvent être des annotations ou des mesures effectuées sur l'aéronef, par exemple la longueur d'une pièce. Lorsque plusieurs mesures et/ou plusieurs annotations sont effectuées sur un même point ou sur des points proches, ces informations de réalisation 35-39 peuvent être imbriquées pour limiter l'affichage de la dernière information pertinente. Les informations de réalisation 35-39 peuvent également correspondre à des prises de vue en deux ou trois dimensions. Ces prises de vue sont alors adaptées à la maquette numérique 30 et intégrées sur celle-ci. A l'aide de toutes ces fonctionnalités, les opérateurs de contrôle qui détectent une non-conformité entre le produit semi-fini et la maquette numérique 30 peuvent référencer clairement l'information.

Afin de faciliter la lecture de toutes ces informations de réalisation 35-39, l'environnement de spatialisation 31 peut comporter des moyens pour masquer les informations dont la position spatiale mesurée n'est pas visible par l'opérateur. L'environnement de spatialisation 31 peut également comporter plusieurs niveaux de détails 50 associés à plusieurs masques. L'opérateur peut ainsi sélectionner le niveau de détail qu'il souhaite visualiser. De même, les informations de réalisation 35-39 peuvent être associées à une date de sorte que l'opérateur puisse masquer certaines informations de réalisation 35-39 de l'environnement de spatialisation 31 en fonction d'une date sélectionnée.

Lorsque le produit est entièrement réalisé, la maquette numérique 30 enrichie par les informations de réalisation 35-39 peut être encore utilisée pour les opérations de maintenance. Pour ce faire, un opérateur de maintenance effectue une acquisition de plusieurs informations de maintenance 41-45 qui sont géolocalisées et intégrées sur la maquette numérique 30. Par exemple, en cas de détection d'une crique sur l'empennage d'un aéronef, un scan en trois dimensions de la crique est réalisé puis intégré à la maquette numérique 30. Un bureau d'étude peut alors calculer à partir de la maquette numérique 30 si cette crique doit être réparée ou non en fonction de la structure de l'aéronef au niveau de la crique. De plus, l'évolution de la crique peut être contrôlée au cours du temps pour vérifier qu'elle suit bien le modèle d'endommagement prévu.

L'invention présente ainsi beaucoup d'avantages pour contrôler la réalisation et l'utilisation d'un produit conçu par ordinateur.

D'une part, la maquette numérique 30, réalisée lors de la phase de conception, est enrichie par des données issues du réel qui sont géolocalisées puis alignées sur le modèle de conception. L'opérateur dispose ainsi d'une représentation enrichie du produit permettant de situer ces données et de comprendre l'état et la configuration du produit en cours de fabrication ou en service et d'analyser les écarts entre un état attendu et un état constaté.

D'autre part, un opérateur peut retrouver sur l'objet réel l'ensemble des annotations déjà effectuées de façon, par exemple, à éviter de refaire une mesure ou à compléter le jeu de mesures existantes par une mesure nouvelle dans une zone non explorée ou bien de déclarer une non-conformité avec le modèle de conception.

## Revendications

1. Procédé (10) de génération d'une maquette numérique (30) comportant les étapes suivantes :
- conception (11) d'une maquette numérique (30) en trois dimensions (X, Y, Z) au moyen d'un logiciel de conception assisté par ordinateur (CAO),
- intégration (12) de ladite maquette numérique (30) dans un environnement de spatialisation (31) de ladite maquette numérique (30) permettant de visualiser ladite maquette numérique (30) suivant différents angles de vision,
- réalisation (13) de ladite maquette numérique (30) afin d'obtenir un produit semi-fini, et
- acquisition (14) de plusieurs informations de réalisation (35-39), **caractérisé en ce qu'**il comporte les étapes suivantes, pour chaque information de réalisation :
- mesure (15) d'une position spatiale liée à ladite information de réalisation (35-39), et
- intégration (16) de ladite information de réalisation (35-39) dans l'environnement de spatialisation (31) sur ladite maquette numérique (30) au niveau d'une position de ladite maquette numérique (30) correspondant à la position spatiale mesurée.

2. Procédé selon la revendication 1, **caractérisé en ce que** l'information de réalisation (35-39) correspond à une mesure d'une pièce dudit produit semi-fini.

3. Procédé selon la revendication 1 ou 2, **caractérisé en ce que**, l'information de réalisation (35-39) correspondant à une prise de vue d'une partie dudit produit semi-fini, le procédé comporte une étape d'adaptation de ladite prise de vue à ladite maquette numérique (30).

4. Procédé selon l'une des revendications 1 à 3, **caractérisé en ce que**, l'information de réalisation (35-39) correspondant à une mesure en trois dimensions (X, Y, Z) d'une surface dudit produit semi-fini, le procédé comporte une étape de mise en correspondance et d'intégration de ladite surface adaptée à ladite maquette numérique (30).

5. Procédé selon l'une des revendications 1 à 4, **caractérisé en ce que**, l'information de réalisation (35-39) correspondant à une pluralité d'annotations relatives à une même position spatiale, le procédé comporte une étape d'imbrication des annotations ponctuelles localisées dans une même zone.

6. Procédé selon l'une des revendications 1 à 5, **caractérisé en ce que**, l'environnement de spatialisation (31) comportant plusieurs niveaux de détails (50) associés à plusieurs masques, le procédé comporte une étape consistant à masquer certaines informations de réalisation (35-39) ou certaines informations de ladite maquette numérique (30) en fonction d'un niveau de détail (50) sélectionné.

7. Procédé selon l'une des revendications 1 à 6, **caractérisé en ce qu'**il comporte une étape consistant à masquer certaines informations de réalisation (35-39) ou certaines informations de ladite maquette numérique (30) en fonction de la position de visualisation dans ledit environnement de spatialisation (31).

8. Procédé selon l'une des revendications 1 à 7, **caractérisé en ce que**, certaines informations de réalisation (35-39) étant associées à une date, le procédé comporte une étape consistant à masquer certaines informations de réalisation (35-39) en fonction d'une date sélectionnée.

9. Procédé selon l'une des revendications 1 à 8, **caractérisé en ce qu'**il comporte les étapes suivantes :
- acquisition (20) de plusieurs informations de maintenance (41-45), et, pour chaque information de maintenance (41-45) :
- mesure (21) d'une position spatiale liée à ladite information de maintenance (41-45), et
- intégration (22) de ladite information de maintenance (41-45) dans l'environnement de spatialisation (31) sur ladite maquette numérique (30) au niveau d'une position de ladite maquette numérique (30) correspondant à la position spatiale mesurée.
